(19) Europäisches Patentamt / European Patent Office / Office européen des brevets

(11) **EP 2 278 708 B1**

(12) **FASCICULE DE BREVET EUROPEEN**

(45) Date de publication et mention de la délivrance du brevet:
**05.12.2018 Bulletin 2018/49**

(51) Int Cl.:
*H03H 3/02* *(2006.01)*    *H03H 3/04* *(2006.01)*
*H03H 9/02* *(2006.01)*    *H03H 9/58* *(2006.01)*
*H03H 9/64* *(2006.01)*

(21) Numéro de dépôt: **10167447.1**

(22) Date de dépôt: **28.06.2010**

(54) **Dispositif résonant à ondes acoustiques guidées et procédé de réalisation du dispositif**

Mit geführten akustischen Wellen arbeitende Resonanzvorrichtung und Herstellungsverfahren

Resonant device utilising guided acoustic waves and manufacturing method

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **30.06.2009 FR 0903186**

(43) Date de publication de la demande:
**26.01.2011 Bulletin 2011/04**

(73) Titulaires:
• **Commissariat à l'Énergie Atomique et aux Énergies Alternatives**
**75015 Paris (FR)**
• **STMicroelectronics SA**
**92120 Montrouge (FR)**

(72) Inventeurs:
• **Reinhardt, Alexandre**
**38000 Grenoble (FR)**
• **Kone, Issiaka**
**73000 Chambéry (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
FR-A- 2 882 205        JP-A- 2005 223 808
JP-A- 2008 113 061     US-A- 5 726 610
US-A1- 2002 093 399    US-A1- 2004 227 587
US-A1- 2007 241 841    US-A1- 2008 067 891
US-B1- 6 441 703

• KUYPERS J H ET AL: "Green's function analysis of Lamb wave resonators" ULTRASONICS SYMPOSIUM, 2008, 2 novembre 2008 (2008-11-02), pages 1548-1551, XP031443376

EP 2 278 708 B1

**Description**

Le domaine de l'invention est celui des dispositifs électromécaniques exploitant la propagation d'ondes acoustiques dans des couches minces piézoélectriques en vue notamment de réaliser un dispositif résonant pour des fonctions de capteur, base de temps ou de filtre électrique tel qu'un filtre passe bande.

De tels dispositifs présentent des fréquences de fonctionnement de l'ordre de quelques centaines de MHz à quelques GHz, et sont utilisés dans des circuits de transmission radiofréquence (téléphone portable, liaison radio, échange de données sans fil,...), de traitement du signal ou dans des systèmes de capteurs.

De manière générale, les résonateurs à ondes guidées exploitent la capacité d'un matériau piézoélectrique à se déformer sous l'application d'un champ électrique. En présence d'un signal électrique alternatif, des ondes acoustiques sont générées. Lorsque ces ondes sont structurellement confinées dans une partie de la structure (par exemple, une couche), on parle alors d'ondes guidées. L'exemple le plus générique est celui des ondes de Lamb, qui correspondent à des ondes se propageant dans une plaque, et confinées dans cette plaque étant donné leur réflexion aux interfaces solide/air. Le confinement peut également être apporté par l'impossibilité pour les ondes à se propager dans un milieu donné en raison de réflexions internes totales (analogue au confinement de la lumière dans une fibre optique). Il peut également être amené par l'utilisation d'un miroir acoustique. Par effet piézoélectrique inverse, les contraintes associées à la propagation d'une onde élastique entrainent la génération d'un courant électrique dans les électrodes, ce qui se traduit par une résonance électrique.

Ces résonateurs se présentent par conséquent sous la forme d'une couche piézoélectrique, éventuellement déposée sur un empilement de couches appelé miroir de Bragg, capable de réfléchir les ondes acoustiques, quelles que soient leurs polarisations, et ainsi de les confiner dans le milieu piézoélectrique. Une structure de couche suspendue ou déposée sur un miroir de Bragg permet d'isoler le résonateur dans la direction verticale et d'éviter des pertes par rayonnement acoustique dans le substrat. Des électrodes sont positionnées soit à la surface, soit de part et d'autre de la couche piézoélectrique, de manière à exciter un champ électrique dans le matériau actif comme décrit dans les demandes de brevet ou brevet cités ci-après : A. Khelif, A. Choujaa et V. Laude, *Dispositif à ondes acoustiques haute fréquence* WO 2006/087496 A1, R. Aigner et J. Ella, Component for forming vertically standing waves of a wavelength US 6734600B2, R.F. Milsom, F.W. Vanhelmont, A. Jansman, J. Ruigrok et H.P. Loebl, *Bulk acoustic wave resonator device* WO 2006/126168A1. , J. Kuypers et A. Pisano, *Green's Function Analysis of Lamb Wave Resonators,* US2007/0241841.

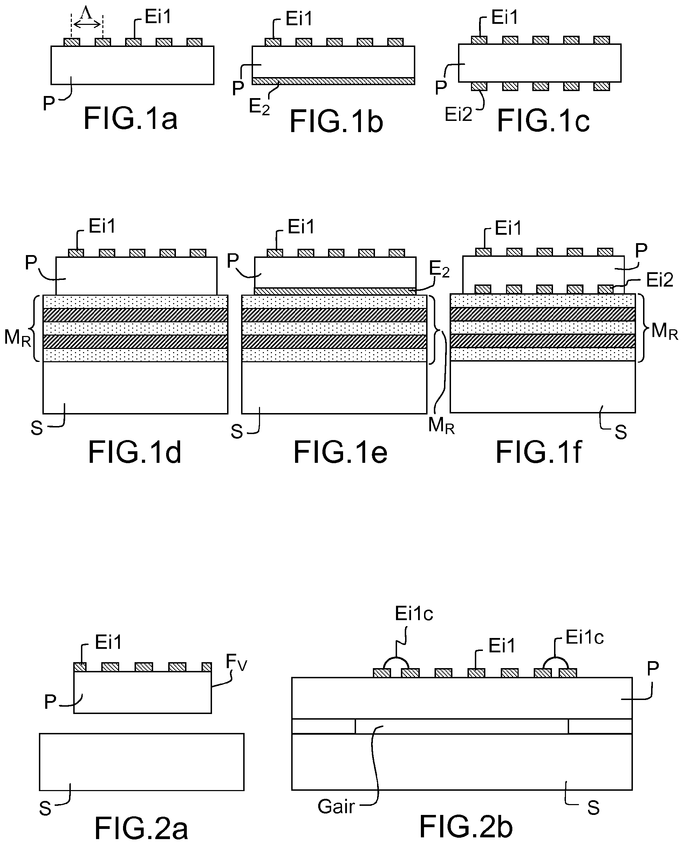

Les électrodes supérieures présentent l'aspect de deux peignes interdigités $E_{i1}$ dont la période $\Lambda$ est égale à une demi-longueur d'onde et sont réalisées à la surface d'une plaque de matériau piézoélectrique P. Les électrodes inférieures, si elles existent, peuvent soit se limiter à un plan électrique $E_2$, soit être elles aussi sous la forme de deux peignes interdigités $E_{i2}$. Ces différentes structures de résonateurs sont représentées respectivement sur les figures 1a à 1c.

Des structures de résonateurs à ondes guidées sont représentées sur les figures 1d à 1f en utilisant des structures de miroir de Bragg MR réalisées à la surface d'un substrat S, pour confiner les ondes acoustiques dans le matériau piézoélectrique. Dans tous les cas, la périodicité des électrodes fixe la fréquence de résonance, puisque ces deux grandeurs sont reliées par l'intermédiaire de la vitesse de propagation de l'onde :

$$\lambda = \frac{V}{f},$$

où $\lambda$ est la longueur d'onde, $V$ la vitesse de propagation de l'onde et $f$ la fréquence de résonance.

Pour éviter les fuites d'énergie sur les bords des résonateurs, il est couramment admis de limiter la couche piézoélectrique dans laquelle se propagent les ondes par un flanc vertical Fv comme illustré en figure 2a. La disposition exacte de ce flanc dépend du mode de vibration exploité, mais doit également correspondre à un ventre de vibration pour perturber le moins possible le fonctionnement du résonateur. Il est à noter que cette gravure peut également se prolonger plus profondément par une gravure des couches du miroir de Bragg, voire du substrat.

Il est également possible d'utiliser un réseau réflecteur composé d'électrodes court-circuitées $E_{i1c}$ comme illustré en figure 2b dans le cas d'un dispositif comportant une membrane réalisé à la surface d'un substrat S en matériau piézoélectrique P, permettant de créer un gap d'air $G_{air}$ assurant une fonction de confinement des ondes acoustiques dans le matériau piézoélectrique et permettant par la même de s'affranchir d'une structure de miroir de Bragg.

La réponse électrique de résonateurs à ondes guidées se traduit par de brusques variations de l'impédance électrique en fonction de la fréquence. Une grandeur clé dans ce type de composants est le coefficient de couplage piézoélectrique. Une mesure de ce coefficient est accessible par la formule suivante :

$$k^2 = \frac{f_a - f_r}{f_a},$$

où $f_r$ est la fréquence de résonance (correspondant à une impédance minimale du résonateur) et $f_a$ la fréquence d'antirésonance (correspondant à une impédance maximale du résonateur).

Pour réaliser un filtre par exemple passe bande, généralement au moins deux résonateurs sont nécessaires. Un filtre passe bande est obtenu de manière connue par association électrique ou par couplage acoustique des résonateurs, ces associations ou couplages étant destinés à permettre au signal électrique de traverser le composant complet uniquement sur une certaine gamme de fréquence, et de bloquer ce passage sur le reste du spectre.

De même, il est possible de réaliser une banque de filtres. Un tel composant associe plusieurs filtres ayant approximativement la même largeur de bande, mais tous décalés les uns par rapport aux autres, de manière à ne permettre le passage pour chacun d'entre eux que d'une partie d'un spectre plus large. Un exemple bien connu peut être de fournir une banque de filtres permettant pour chaque filtre de filtrer un canal de télévision ou de radio. Tous les filtres devant présenter la même largeur de bande, il est nécessaire de proposer des résonateurs à différentes fréquences mais avec des coefficients de couplage piézoélectriques comparables.

Ainsi à partir de résonateur à ondes guidées exploitant un mode de vibration en épaisseur, noté TE1 (pour *Thickness Extensional 1*), il est aisé de réaliser des filtres à des fréquences différentes : il suffit de modifier les paramètres géométriques, et notamment la période des électrodes d'excitation.

Un exemple d'empilement est résumé dans le tableau T1 ci-après, à savoir l'empilement de couches Mo, $SiO_2$, SiN, SiOC,SiN, SiOC constituant un miroir de Bragg, la couche piézoélectrique étant en AlN recouverte de SiN faisant office de couche de passivation.

Tableau T1

| Couche | Epaisseur |
|---|---|
| SiN | 250 nm |
| AlN | 1850 nm |
| Mo | 300 nm |
| $SiO_2$ | 210 nm |
| SiN | 1500 nm |
| SiOC | 270 nm |
| SiN | 1500 nm |
| SiOC | 270 nm |
| Silicium | (considéré semi-infini) |

Par exemple des filtres à 2 GHz, 1,98 GHz et 1,96 GHz peuvent être réalisés par le couplage de deux résonateurs comme décrits ci-après :

Filtre centré sur 2 GHz :

| | Résonateur 1 | Résonateur 2 |
|---|---|---|
| Epaisseur $SiO_2$ | 210 nm | |
| Période | 10 $\mu$m | 8.5 $\mu$m |
| fr | 1984.5 MHz | 2000 MHz |
| fa | 1999.5 MHz | 2012.4 MHz |
| $k^2$ | 0.75 % | 0.61 % |

Filtre centré sur 1.98 GHz

|  | Résonateur 1 | Résonateur 2 |
|---|---|---|
| Epaisseur SiO$_2$ | 210 nm | |
| Période | 13.7 $\mu$m | 10.4 $\mu$m |
| fr | 1958.7 MHz | 1980.6 MHz |
| fa | 1979.7 MHz | 1996.5 MHz |
| k$^2$ | 1.06 % | 0.80 % |

Filtre centré sur 1.96 GHz

|  | Résonateur 1 | Résonateur 2 |
|---|---|---|
| Epaisseur SiO$_2$ | 210 nm | |
| Période | 26.7 $\mu$m | 13.4 $\mu$m |
| fr | 1930.2 MHz | 1960.2 MHz |
| fa | 1960.2 MHz | 1980.9 MHz |
| k$^2$ | 1.53 % | 1.04 % |

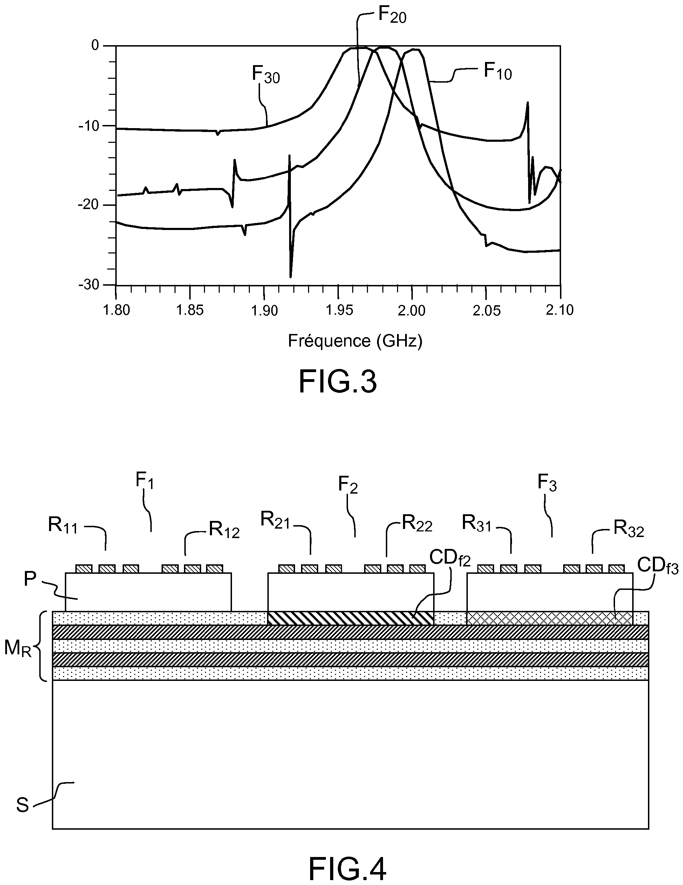

Néanmoins, on réalise dans ce cas, une banque de trois filtres à ondes guidées présentant des largeurs de bande différentes respectivement de 18 MHz à 2000 MHz pour le filtre F$_{10}$, de 25 MHz à 1980 mHz pour le filtre F$_{20}$ et de 40 MHz à 1960 MHz pour le filtre F$_{30}$, comme illustré en figure 3.

La demanderesse est partie du constat que pour assurer une transmission constante dans une bande utile donnée (cette bande utile correspond à la bande passante dans le cas d'un filtre passe bande), il était nécessaire d'ajuster approximativement la fréquence d'antirésonance d'un premier type de résonateur avec la fréquence de résonance d'un second type de résonateur, ce qui correspond au coefficient de couplage piézoélectrique vu ci-dessus, fixant par la même directement la largeur de bande atteignable.

Le but recherché dans la présente invention est ainsi de garantir l'homogénéité du coefficient de couplage en fonction de la fréquence, pour chacun des filtres d'une banque de filtres basés sur des résonateurs à ondes guidées.

Le principe de l'invention consiste à exploiter les dépendances du coefficient de couplage et de la fréquence de résonance vis-à-vis des propriétés de propagation des ondes acoustiques liées à des éléments intrinsèques de la structure (architecture des électrodes, couche appartenant à l'empilement technologique utilisé dans le dispositif, appelée ci-après couche différenciation,...).

Des variations de propriétés de propagation (vitesse de propagation et/ou masse) affectent en effet de manière significative le coefficient de couplage et la fréquence de résonance et ce de manière d'autant plus marquée que la modification intervient dans une région de la structure dans laquelle les champs acoustiques sont les plus élevés.

Plus précisément, le principe de la présente invention consiste à exploiter la dépendance du coefficient de couplage aux propriétés de propagation d'une des couches de l'empilement technologique, appelée ci-après couche de différenciation. Des variations de propriétés de propagation (vitesse de propagation et/ou masse) de cette couche doivent affecter de manière significative le coefficient de couplage, aussi celle-ci doit elle être localisée dans une région de la structure où les champs acoustiques sont les plus forts.

Plus précisément la présente invention a pour objet un dispositif résonant à ondes acoustiques guidées selon la revendication 1. Les revendications dépendantes définissent des variantes avantageuses.

L'invention sera mieux comprise et d'autres avantages apparaîtront à la lecture de la description qui va suivre donnée à titre non limitatif et grâce aux figures annexées parmi lesquelles :

- les figures 1a à 1f illustrent des structures de résonateurs à ondes acoustiques guidées réalisées sur miroirs de Bragg selon l'art connu ;
- les figures 2a et 2b illustrent des exemples de structures de résonateurs à ondes de Lamb permettant de limiter les fuites d'énergie ;
- la figure 3 illustre les performances obtenues avec un exemple de banque de 3 filtres comportant une structure de résonateurs à ondes guidée basée sur l'empilement du décrit dans le tableau T1 ;
- la figure 4 illustre une première variante du dispositif de l'invention ;
- la figure 5 illustre la variation du coefficient de couplage en fonction de la fréquence pour le composant à ondes guidées résumé dans le tableau T1.
- la figure 6 illustre la variation du coefficient de couplage en fonction de la fréquence pour plusieurs épaisseurs de la couche supérieure du miroir de Bragg ;
- la figure 7 illustre les réponses de filtres à 1.96, 1.98 et 2.00 GHz réalisés avec des empilements présentant des épaisseurs respectives de la couche supérieure du miroir de Bragg de 510, 310 et 210 nm dans un exemple de dispositif de l'invention ;
- les figures 8a à 8d illustrent les étapes de réalisation d'une première variante de dispositif de l'invention ;
- les figures 9a à 9d illustrent les étapes de réalisation d'une deuxième variante de l'invention ;
- les figures 10a à 10d illustrent les étapes de réalisation d'une troisième variante de l'invention ;
- les figures 11a à 11f illustrent les étapes de réalisation d'une quatrième variante de l'invention ;
- les figures 12a à 12f illustrent les étapes de réalisation d'une cinquième variante de l'invention ;
- les figures 13a à 13f illustrent les étapes de réalisation d'une sixième variante de l'invention.

De manière générale le dispositif de l'invention peut avantageusement comprendre de manière connue, à la surface d'un substrat un miroir de Bragg réalisé par un empilement de couches, à la surface duquel est positionné le matériau piézoélectrique dans lequel peuvent se propager des ondes acoustiques de type ondes de Lamb.

Des électrodes supérieures avantageusement réalisées sous forme de peignes d'électrodes interdigitées sont positionnées à la surface dudit matériau piézoélectrique pour permettre à partir d'une excitation électrique, la génération et la propagation des ondes acoustiques. Elles comportent des motifs périodiques de pas dont le réglage permet d'ajuster le coefficient de couplage dudit résonateur.

De manière à bénéficier d'un degré supplémentaire d'optimisation des coefficients de couplage, la présente invention propose d'associer les règles de dessin des électrodes des peignes interdigités et donc le pas des réseaux d'électrodes, avec l'introduction d'une couche appelée couche de différenciation, de telle façon que les propriétés de propagation des ondes puissent être modifiées avec une plus grande latitude.

Nous allons décrire ci-après le dispositif de l'invention dans le cadre de résonateurs réalisés à la surface de miroir de Bragg, mais l'invention peut être appliquée de manière plus générale à des dispositifs sans miroir de Bragg, typiquement dans des structures à membrane comportant des gaps d'air permettant d'isoler les ondes acoustiques au sein du matériau piézoélectrique.

Par souci de simplification, le reste de la description est basée sur des résonateurs formant des filtres passe bande.

Dans cette configuration, le dispositif comprend comme illustré en figure 4, un ensemble par exemple de 3 filtres $F_1$, $F_2$ et $F_3$.

Chaque filtre comporte deux résonateurs respectivement $R_{11}$ et $R_{12}$, $R_{21}$ et $R_{22}$, $R_{31}$ et $R_{32}$, réalisés à la surface de la structure de miroir de Bragg et comportant des peignes d'électrodes interdigitées, respectivement de pas d'électrodes $\Delta_{11}$, $\Delta_{12}$, $\Delta_{21}$, $\Delta_{22}$, $\Delta_{31}$, $\Delta_{32}$ (non représentés).

Les largeurs de bande $B_1$, $B_2$, $B_3$ des filtres $F_1$, $F_2$ et $F_3$ sont en première approximation de l'ordre de $k^2$ si l'on considère qu'au sein d'un même filtre les fréquences de résonance sont proches ainsi que les fréquences d'antirésonance.

$$k^2 = \frac{f_a - f_r}{f_a},$$

Selon l'exemple illustré en figure 4, le dispositif comporte en outre deux couches de différenciation $CDf_2$ et $CDf_3$ qui peuvent typiquement être des éléments situés au niveau de la couche supérieure du miroir de Bragg.

En effet, toute modification de l'épaisseur entraîne une variation de la phase du coefficient de réflexion du miroir de Bragg, causée par une variation du chemin acoustique des ondes pénétrant puis ressortant de ce miroir. Cette variation agit au premier ordre sur la fréquence de résonance, et sur les conditions aux limites du guide d'onde (la couche piézoélectrique), ce qui provoque également une variation du coefficient de couplage piézoélectrique.

La variation de fréquence de résonance est par ailleurs compensée par une variation de la période des électrodes en forme de peignes interdigités de manière à ce que seule subsiste la variation du coefficient de couplage piézoélectrique et non plus également un changement de fréquence.

Une variation de densité peut avoir des effets similaires : une telle modification du milieu peut être obtenue en venant porosifier le matériau employé par exemple, en faisant varier la porosité d'une couche de silicium poreux comme décrit dans les publications suivantes : R.J.M. Da Fonseca, J.M. Saurel, G. Despaux, A. Foucaran, E. Massonne, T. Talierco et P. Lefebvre, Superlattices Microstruct. Vol. 16, p. 21 (1994), D. Bellet, P. Lamagnère, A. Vincent et Y. Bréchet, J. Appl. Phys. Vol 80, p. 3772 (1996), G.T. Andrews, J. Zuk, H. Kiefte, M.J. Clouter et E. Nossarzewska-Orlowska, Appl. Phys. Lett. Vol. 69, p. 1217 (1996) ou en venant structurer artificiellement selon des motifs de taille négligeable devant la longueur d'onde, de manière à ce que le milieu et ses inclusions se comportent quasiment comme un matériau homogène comme décrit dans le brevet US 6 657 363 B1 de R. Aigner, *Thin Film Piezoelectric Resonator.*

La couche de différenciation peut également être une couche plus profonde du miroir de Bragg, mais dans ce cas, des variations de propriétés beaucoup plus importantes sont à prévoir pour un même effet global recherché sur le résonateur.

De manière alternative, il est possible de jouer de la même manière sur des couches déposées par-dessus les résonateurs à ondes guidées, qu'ils utilisent un miroir de Bragg ou non. Dans ce dernier cas, on peut même envisager de positionner cette couche sous le résonateur.

Il est enfin possible de cumuler les différentes approches.

En pratique, en venant modifier la ou les couches de différenciation localement aux endroits où sont réalisés les différents filtres de la banque, on peut parvenir à fournir plusieurs empilements réalisés sur une même plaque permettant la réalisation de filtres ayant des largeurs de bande égales bien qu'ils visent des fréquences différentes.

Les couches de différenciation ne sont pas forcément réalisées en utilisant le même matériau, ce qui peut permettre de tirer partie de sélectivités de gravure pour ne pas dégrader la couche inférieure. Dans tous les cas de figures, ces couches doivent modifier les propriétés de propagation des ondes guidées, mais sans toutefois dégrader le confinement apporté par le miroir de Bragg.

Exemple de réalisation

En accord avec la présente invention, il est possible de modifier l'empilement localement au niveau de chaque filtre, intégrant par la même des couches de différenciation au niveau de la structure miroir de Bragg.

Dans le cas d'un empilement tel que celui décrit précédemment dans le tableau T1, il est possible en modifiant l'épaisseur de la couche supérieure du miroir de Bragg, soit l'épaisseur de la couche de $SiO_2$, d'influencer le coefficient de couplage.

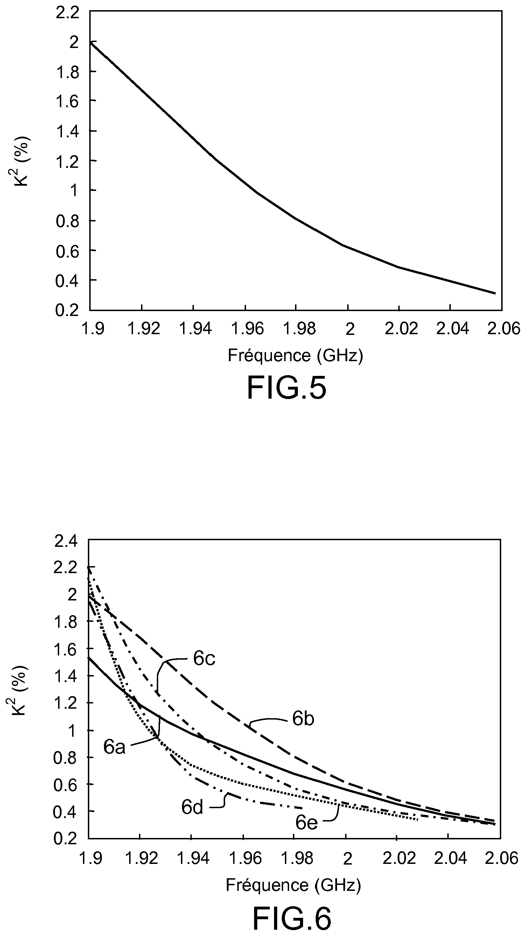

La figure 5 illustre à ce titre la variation du coefficient de couplage en fonction de la fréquence pour le composant à ondes guidées résumé dans le tableau T1.

La figure 6 montre l'évolution de ce coefficient de couplage pour plusieurs épaisseurs de couche de $SiO_2$ supérieure, du miroir de Bragg. Il apparait très clairement que pour pouvoir assurer un coefficient de couplage similaire pour les différents résonateurs (de l'ordre de 0.6 %), il est nécessaire d'utiliser une épaisseur de 210 nm pour cette couche pour le filtre à 2 GHz, une épaisseur de 310 nm pour le filtre à 1.98 GHz et une épaisseur de 510 nm pour le filtre à 1.96 GHz.

Ceci est lié au fait que des variations de l'épaisseur de la couche supérieure du miroir de Bragg entrainent un changement des conditions aux limites apportées à la couche guidante, et de ce fait entrainent une modification du coefficient de couplage piézoélectrique effectif.

L'évolution de cette variation n'est toutefois pas la même à toutes les fréquences comme le montrent les croisements entre courbes visibles constituant l'abaque de la figure 6.

La courbe 6a correspond à une épaisseur de 110 nm.

La courbe 6b correspond à une épaisseur de 210 nm.

La courbe 6c correspond à une épaisseur de 310 nm.

La courbe 6d correspond à une épaisseur de 410 nm.

La courbe 6e correspond à une épaisseur de 510 nm.

En utilisant une telle abaque et donc en intégrant des couches de différenciation en $SiO_2$ d'épaisseurs différentes, il devient possible d'uniformiser les largeurs de trois filtres $F_1$, $F_2$ et $F_3$ réalisés avec les empilements décrits dans le tableau T1 (aux couches de $SiO_2$ près qui sont différenciées).

Les caractéristiques d'un exemple de dispositif de l'invention comportant trois filtres comprenant une structure de miroir de Bragg et au sein duquel les couches de différenciation ont été réalisées en modifiant l'épaisseur de la couche supérieure de $SiO_2$ présente au niveau de la structure de miroir de Bragg sont données ci-après :

Filtre $F_1$ : centré sur 2 GHz

|  | Résonateur 1 | Résonateur 2 |
|---|---|---|
| Epaisseur SiO$_2$ | 210 nm |  |
| Période | 10 $\mu$m | 8.5 $\mu$m |
| Fr | 1984.5 MHz | 2000 MHz |
| Fa | 1999.5 MHz | 2012.4 MHz |
| k$^2$ | 0.75 % | 0.61 % |

Filtre F$_2$ : centré sur 1.98 GHz

|  | Résonateur 1 | Résonateur 2 |
|---|---|---|
| Epaisseur SiO$_2$ | 310 nm |  |
| Période | 7 $\mu$m | 6.3 $\mu$m |
| Fr | 1964.1 MHz | 1979.7 MHz |
| Fa | 1978.5 MHz | 1991.1 MHz |
| k$^2$ | 0.72 % | 0.57 % |

Filtre F$_3$ : centré sur 1.96 GHz

|  | Résonateur 1 | Résonateur 2 |
|---|---|---|
| Epaisseur SiO$_2$ | 510 nm |  |
| Période | 4.6 $\mu$m | 4.4 $\mu$m |
| Fr | 1948.2 MHz | 1957.8 MHz |
| Fa | 1959.6 MHz | 1968.0 MHz |
| k$^2$ | 0.58 % | 0.51 % |

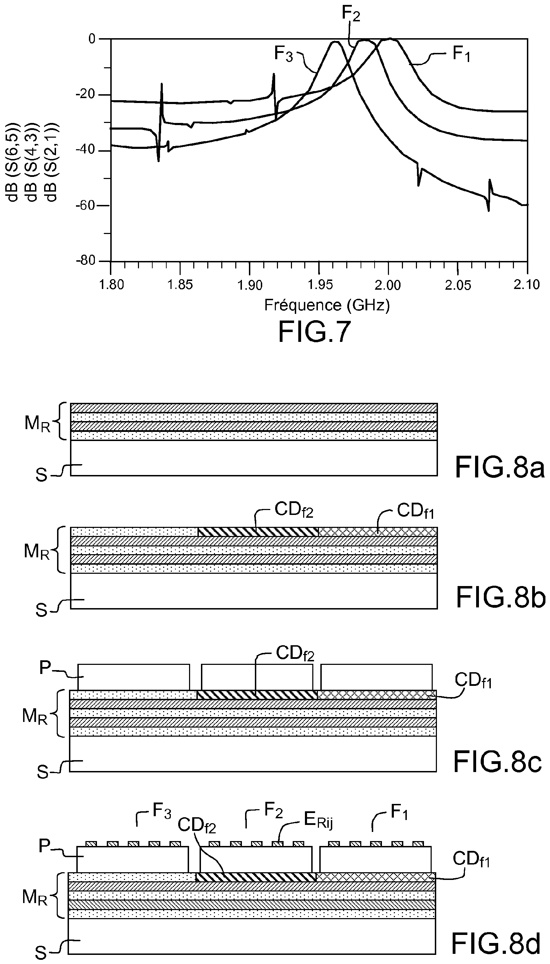

Les performances de cet exemple de banque de filtres sont illustrées en figure 7 qui fournit les réponses par les courbes F$_3$, F$_2$ et F$_1$ des trois filtres à 1.96, 1.98 et 2.00 GHz réalisés avec des empilements présentant des épaisseurs respectives de la couche supérieure du miroir de Bragg de 510, 310 et 210 nm.
Ces courbes valident le fait que l'on parvienne à réaliser des filtres ayant des largeurs de bande sensiblement égales.

Exemples de réalisation du dispositif selon l'invention :

Selon un premier mode de réalisation d'un exemple de dispositif de l'invention, les différentes étapes illustrées en figures 8a à 8d sont les suivantes :

- Etape 1 illustrée en figure 8a : on réalise le dépôt des couches formant le miroir de Bragg M$_R$ à la surface d'un substrat S. Si des couches métalliques sont utilisées, ces couches doivent être structurées pour éviter tout couplage capacitif parasite entre résonateurs ;
- Etape 2 illustrée en figure 8b : on réalise des couches de différenciation CDf$_1$ et CDf$_2$. Pour cela, on grave des motifs petits par rapport à la longueur d'onde, de manière à réduire la densité effective de la couche ainsi que son uniformité. Ces motifs peuvent être remplis par un autre matériau, puis planarisés, de manière à fournir un milieu se présentant comme un compromis entre le matériau formant la matrice et le matériau formant les inclusions. Le rapport volumique entre les inclusions et la matrice est alors varié de manière à fournir un milieu effectif différent pour chaque résonateur. Cette variation de propriétés est définie par les motifs de photolithographie. Il est donc possible d'envisager un grand nombre de variations sans ajouter d'étape technologique supplémentaire. Une alternative peut être de porosifier la couche, en faisant varier la porosité de place en place pour parvenir au même effet. Néanmoins ceci nécessite un masquage spécifique à chaque composant réalisé, ce qui peut s'avérer couteux ;

- Etape 3 illustrée en figure 8c on réalise le dépôt d'une couche de matériau piézoélectrique P que l'on structure de manière à délimiter les trois filtres $F_1$, $F_2$ et $F_3$.
- Etape 4 illustrée en figure 8d, on dépose une couche métallique sur les différents éléments structurés de matériau piézoélectrique, que l'on structure de manière à réaliser les peignes d'électrodes interdigitées $E_{Rij}$ constitutifs des électrodes supérieures.

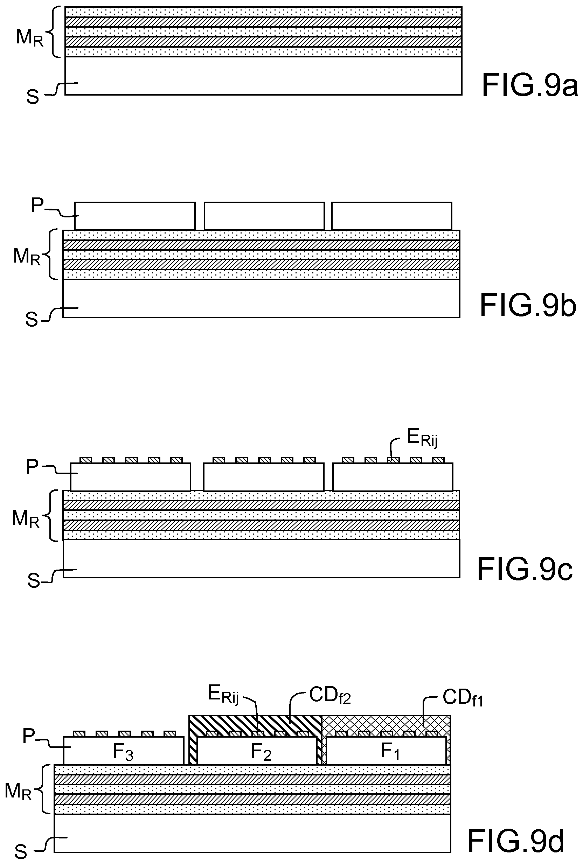

Selon un second mode de réalisation les différentes étapes illustrées en figures 9a à 9d sont les suivantes :

- Etape 1 illustrée en figure 9a : On procède aux dépôts des couches formant le miroir de Bragg MR. Si des couches métalliques sont utilisées, ces couches doivent être structurées pour éviter tout couplage capacitif parasite entre résonateurs ;
- Etape 2 illustrée en figure 9b : On dépose et l'on structure une couche de matériau piézoélectrique de manière à délimiter les trois filtres $F_1$, $F_2$ et $F_3$ ;
- Etape 3 illustrée en figure 9c : On dépose une couche métallique sur les différents éléments structurés de matériau piézoélectrique, que l'on structure de manière à réaliser les peignes d'électrodes interdigitées constitutifs des électrodes supérieures $E_{Rij}$ ;
- Etape 4 illustrée en figure 9d : On dépose et on structure une couche supérieure. Cette couche est ensuite gravée de motifs sub-longueurs d'onde, éventuellement remplis d'un matériau de remplissage, mais ceci n'est pas nécessaire, de manière à fournir un métamatériau présentant des propriétés effectives situées entre celles de l'inclusion et de la matrice, modulé par le rapport volumique entre inclusions et matrice. Ces rapports volumiques sont variés de résonateur en résonateur pour parvenir à l'effet voulu et permettent de définir les deux couches $CDf_1$ et $CDf_2$. L'intérêt de cette solution est que la différenciation est entièrement contrôlée par les motifs de photolithographie utilisés, donc par le concepteur. Une alternative peut être de porosifier le matériau, en faisant varier la porosité localement. Par rapport à la structuration, cette solution nécessite toutefois une série de masquages permettant d'isoler chaque résonateur ou filtre.

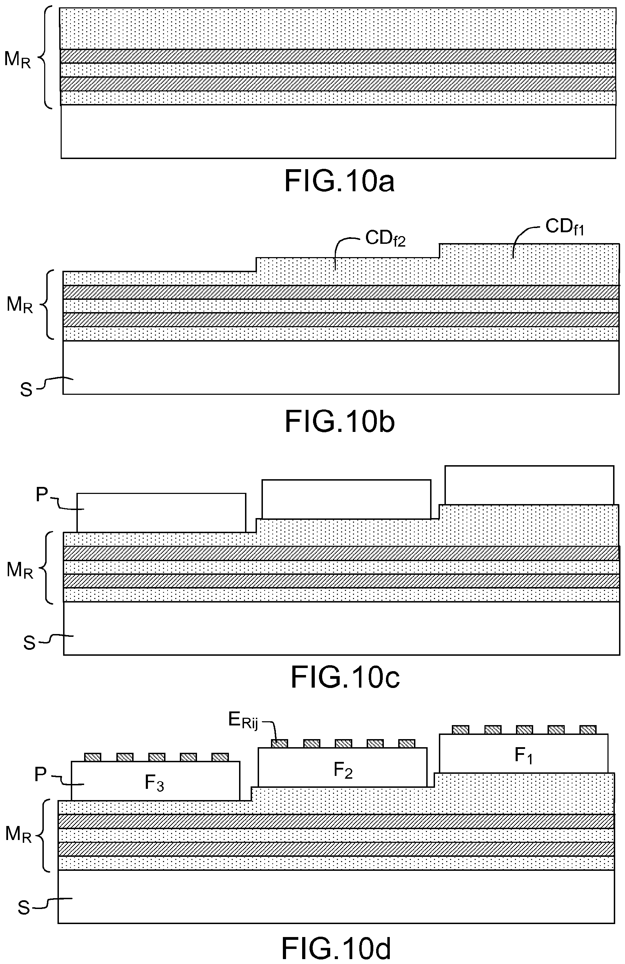

Selon un troisième mode de réalisation les différentes étapes illustrées en figures 10a à 10d sont les suivantes :

- Etape 1 illustrée en figure 10a : on procède aux dépôts des couches composant le miroir de Bragg. Dans le cas le plus général, de simples dépôts suffisent. Si jamais des matériaux électriquement conducteurs sont utilisés, il peut être utile de structurer les couches métalliques pour éviter tout couplage capacitif entre résonateurs ;
- Etape 2 illustrée en figure 10b : on procède à une succession de gravures partielles destinées à fournir plusieurs épaisseurs pour la couche supérieure du miroir de Bragg permettant de définir des couches de différenciation $CD_{f1}$ et $CD_{f2}$ d'épaisseurs différentes ;

- Etape 3 illustrée en figure 10c : on procède aux dépôts d'une couche piézoélectrique P. Ceci suit éventuellement le dépôt et la structuration d'une première couche métallique ;
- Etape 4 illustrée en figure 10d : on procède au dépôt d'une couche métallique et à la structuration des électrodes $E_{Rij}$ situées au-dessus de la couche piézoélectrique. Afin de passiver le composant, ou pour répondre à d'autres spécifications, des dépôts supplémentaires peuvent être réalisés.

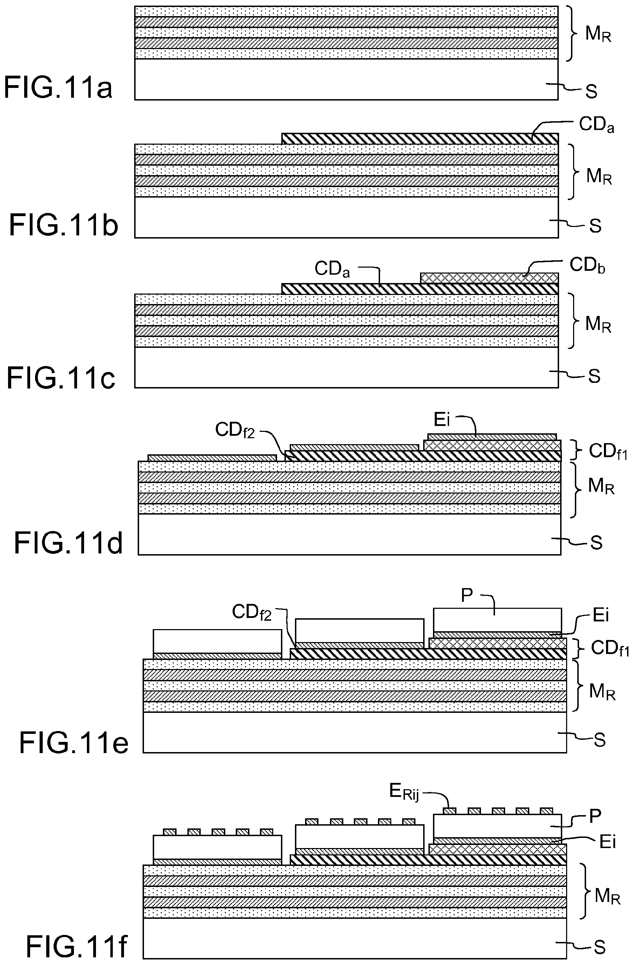

Selon un quatrième mode de réalisation les différentes étapes illustrées en figures 11a à 11f sont les suivantes :

- Etape 1 illustrée en figure 11a : on procède aux dépôts des couches formant le miroir de Bragg MR. Comme pour les cas précédents, si des couches métalliques sont utilisés, ces couches doivent être structurées pour éviter tout couplage capacitif parasite entre résonateurs ;
- Etape 2 illustrée en figure 11b : on procède au dépôt et à la structuration d'une première couche CDa ;
- Etape 3 illustrée en figure 11c : on procède au dépôt et structuration d'une seconde couche $CD_b$ ; l'empilement des couches $CD_a$ et $CD_b$ constitue l'équivalent d'une couche de différenciation $CD_{f1}$ et la couche $CD_b$ seule constitue l'équivalent de la couche de différenciation $CD_{f2}$ ;
- Etape 4 illustrée en figure 11d : on procède au dépôt d'une couche métallique et à la structuration des électrodes inférieures Ei;
- Etape 5 illustrée en figure 11e : on procède au dépôt et à la structuration (si besoin) de la couche piézoélectrique ;
- Etape 6 illustrée en figure 11f : on procède au dépôt et à la structuration des électrodes supérieures. D'autres dépôts peuvent suivre, en vue de passiver, par exemple, les composants.

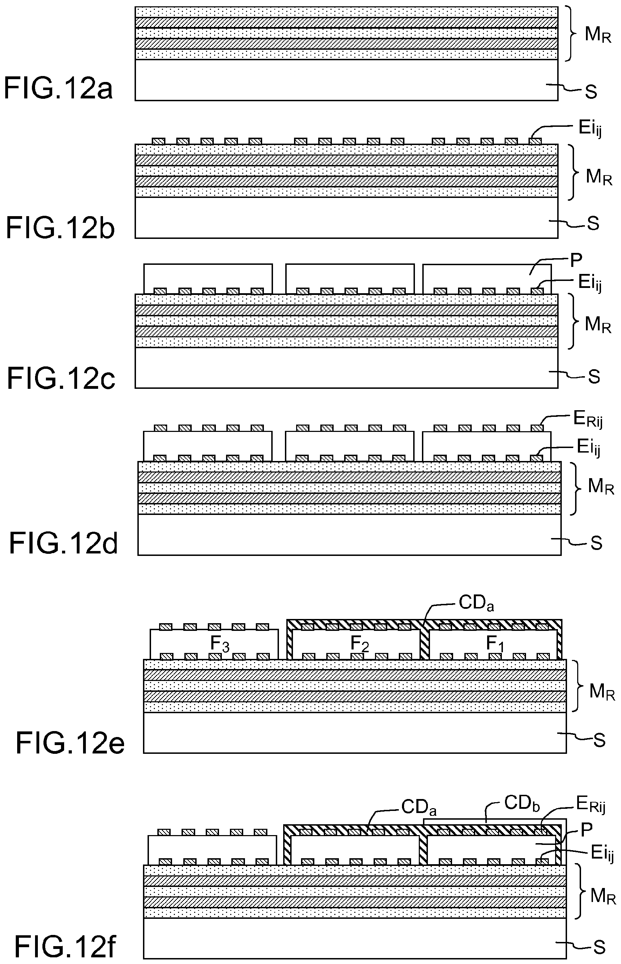

Selon un cinquième mode de réalisation les différentes étapes illustrées en figures 12a à 12f sont les suivantes :

- Etape 1 illustrée en figure 12a : On procède au dépôt des couches formant le miroir de Bragg MR à la surface d'un substrat S. Comme pour les cas précédents, si des couches métalliques sont utilisées, ces couches doivent être structurées pour éviter tout couplage capacitif parasite entre résonateurs ;
- Etape 2 illustrée en figure 12b : On procède au dépôt et structuration (si besoin) d'électrodes inférieures $Ei_{ij}$ ;
- Etape 3 illustrée en figure 12c : on procède au dépôt et à la structuration (si besoin) de la couche piézoélectrique P ;
- Etape 4 illustrée en figure 12d : on procède au dépôt et à la structuration des électrodes supérieures $E_{Rij}$ ;
- Etape 5 illustrée en figure 12e : on procède au dépôt et à la structuration d'une première couche CDa ;
- Etape 6 illustrée en figure 12f : on procède au dépôt d'une seconde couche CDb. Les couches de différenciation entre filtres $F_1$, $F_2$ et $F_3$ sont constituées respectivement par un empilement des couches CDa et CDb et par la couche CDa. Ce dernier dépôt peut ensuite être suivi de dépôts supplémentaires, à des fins autres que le sujet couvert par cette invention (passivation, par exemple...). De manière alternative, la différenciation entre filtres et/ou résonateurs peut se faire par gravure partielle de cette couche.

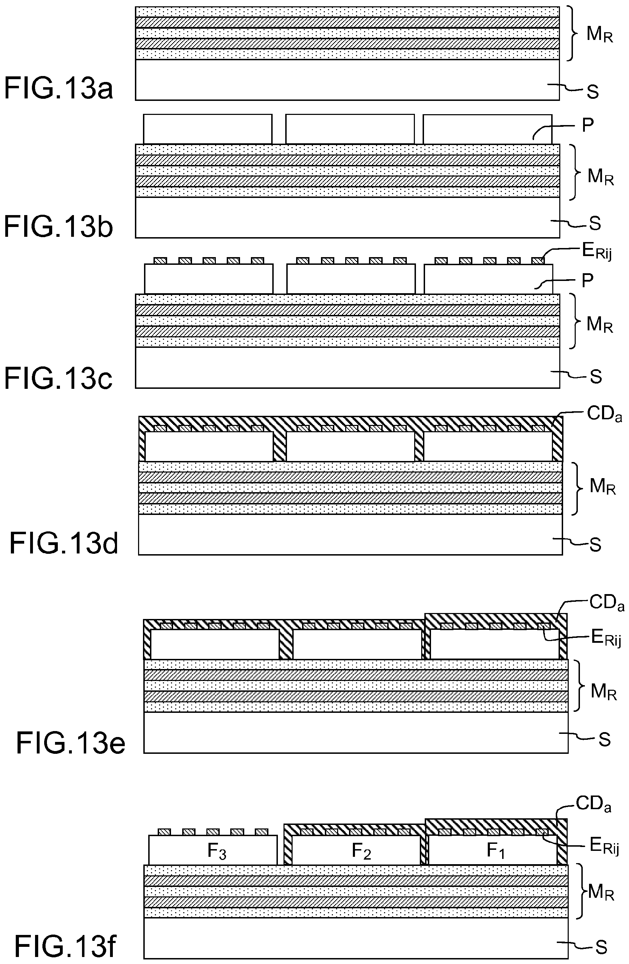

Selon un sixième mode de réalisation les différentes étapes illustrées en figures 13a à 13f sont les suivantes :

- Etape 1 illustrée en figure 13a : On procède au dépôt des couches formant le miroir de Bragg. Comme pour les cas précédents, si des couches métalliques sont utilisées, ces couches doivent être structurées pour éviter tout couplage capacitif parasite entre résonateurs ;
- Etape 2 illustrée en figure 13b : on procède au dépôt et structuration (si besoin) de la couche piézoélectrique P :
- Etape 3 illustrée en figure 13c : on procède au dépôt et structuration des électrodes supérieures $E_{Rij}$ :
- Etape 4 illustrée en figure 13d : on procède au dépôt de la couche CDa qui va servir à former les couches de différenciation ;
- Etape 5 illustrée en figure 13e : on réalise la gravure(s) partielle(s) de la couche CDa ;
- Etape 6 illustrée en figure 13f : on réalise la gravure totale de la couche de différenciation là où elle n'est pas nécessaire. On a ainsi défini au niveau des 3 filtres $F_1$, $F_2$ et $F_3$, une couche de différenciation $CD_{f1}$, une couche de différenciation $CD_{f2}$ et pas de couche de différenciation à partir d'une couche unique et par des opérations de gravure différentes.

Pour chacun de ces modes de réalisation décrits ci-dessus, il a été considéré un type de résonateurs et de filtres différents, mais ceci était uniquement illustratif. Les types de résonateurs peuvent librement être permutés. De même, pour un même mode de réalisation décrit, d'autres structures de résonateurs à ondes guidées que celles décrites peuvent être employées.
De même, il a n'a été décrit que la réalisation de résonateurs utilisant des miroirs de Bragg, mais les mêmes approches peuvent être utilisées sur des structures de résonateurs sur membranes. Typiquement dans le cas de trois filtres, on réalise trois membranes, les couches de différenciation pouvant être aussi bien réalisées au dessus des électrodes supérieures qu'au niveau des gaps d'air des membranes.

**Revendications**

1. Dispositif résonant à ondes acoustiques guidées comprenant :

   - un empilement de couches réalisé à la surface d'un substrat (S) ;
   - au moins deux filtres ($F_1$,...,$F_i$,...,$F_N$) réalisés dans ledit empilement de couches, chaque filtre comprenant au moins deux résonateurs à ondes acoustiques guidées ($R_{11}$-$R_{12}$,... ,$R_{i1}$-$R_{i2}$,... ,$R_{N1}$-$R_{N2}$), chaque filtre étant **caractérisé par** une bande passante utile de fréquences ($BF_1$, ..., $BF_i$,..., $BF_N$) centrée sur une fréquence centrale ($f_1$,... ,$f_i$,... ,$f_N$), lesdites fréquences centrales étant différentes entre elles, chaque résonateur comprenant au moins un jeu d'électrodes supérieures interdigitées présentant une structure périodique de période ($\Lambda_{ij}$) et une couche de matériau piézoélectrique appartenant audit empilement, lesdites électrodes étant situées au niveau d'une face du matériau piézoélectrique opposée à celle en regard dudit substrat, chaque résonateur étant **caractérisé par** un coefficient de couplage ($k^21$, $k^22$, ..., $k^2n$) et une fréquence de résonance ($fr_1$,...,$f_{r2}$,...,$f_N$), **caractérisé en ce que** :
   - au moins un des filtres comprend une couche de différenciation ($CDf_i$) par rapport à l'autre desdits deux filtres appartenant audit empilement ;

- l'épaisseur et/ou la densité de ladite couche de différenciation et la période desdites électrodes étant agencées pour obtenir des largeurs de bande passante utile égales pour lesdits deux filtres.

2. Dispositif résonant à ondes acoustiques guidées comportant un résonateurs selon la revendication 1, **caractérisé en ce que** la ou les couches de différenciation sont positionnées à la surface des résonateurs du ou desdits filtres.

3. Dispositif résonant à ondes acoustiques guidées comportant un résonateur selon l'une des revendications 1 ou 2, **caractérisé en ce que** la ou les couches de différenciation sont positionnées entre les résonateurs du ou desdits filtres et un substrat.

4. Dispositif résonant à ondes acoustiques guidées comportant un ensemble de résonateurs selon la revendication 3, **caractérisé en ce que** les résonateurs des filtres sont réalisés à la surface d'un empilement commun de couches assurant une fonction de miroir de Bragg, ledit miroir de Bragg étant à la surface d'un substrat.

5. Dispositif résonant à ondes acoustiques guidées comportant un ensemble de résonateurs selon la revendication 4, **caractérisé en ce que** la ou les couches de différenciation appartiennent à l'une des couches de l'empilement constitutives du miroir de Bragg.

6. Dispositif résonant à ondes acoustiques guidées comportant un ensemble de résonateurs selon l'une quelconque des revendications 1 à 5, **caractérisé en ce que** la ou les couches de différenciation comportent des éléments poreux permettant d'en modifier les caractéristiques acoustiques.

7. Dispositif résonant à ondes acoustiques guidées comportant un ensemble de résonateurs selon l'une quelconque des revendications 1 à 5, **caractérisé en ce que** la ou les couches de différenciation comportent des motifs sub-longueurs d'onde.

8. Dispositif résonant à ondes acoustiques guidées comportant un ensemble de résonateurs selon l'une des revendications 1 à 7, **caractérisé en ce qu'**au moins une partie des filtres comprend plusieurs couches de différenciation.

9. Dispositif résonant à ondes acoustiques guidées comportant un ensemble de résonateurs selon l'une des revendications 1 à 8, **caractérisé en ce que** les résonateurs desdits filtres comprennent en outre une électrode dite inférieure, en regard de l'électrode supérieure.

10. Dispositif résonant à ondes acoustiques guidées comportant un ensemble de résonateurs selon la revendication 9, **caractérisé en ce que** l'électrode dite inférieure est une électrode continue.

11. Dispositif résonant à ondes acoustiques guidées comportant un ensemble de résonateurs selon la revendication 9, **caractérisé en ce que** l'électrode inférieure est un peigne d'électrodes interdigitées.

12. Dispositif résonant à ondes acoustiques guidées comportant un ensemble de résonateurs selon l'une des revendications 1 à 3 ou 6 à 11, **caractérisé en ce que** le dispositif comprend une structure de membrane couplée aux résonateurs permettant de créer un gap capable de confiner les ondes acoustiques dans le matériau piézoélectrique.

**Patentansprüche**

1. Mit geführten akustischen Wellen arbeitende Resonanzvorrichtung, Folgendes beinhaltend:

- einen Stapel von Schichten, welcher an der Oberfläche eines Substrates (S) gebildet wird;
- mindestens zwei Filter ($F_1$,..,$F_i$,...,$F_N$), welche in dem Stapel von Schichten gebildet sind, wobei jeder Filter mindestens zwei Resonatoren für geführte akustische Wellen ($R_{11}$-$R_{12}$,...,$R_{i1}$-$R_{i2}$,...,$R_{N1}$-$R_{N2}$), beinhaltet, wobei jeder Filter durch ein Nutzfrequenzband ($B_{F1}$,...,$B_{Fi}$,...,$B_{FN}$) gekennzeichnet ist, welches auf eine Mittelfrequenz ($f_1$,...,$f_i$,...$f_N$) zentriert ist, wobei die Mittelfrequenzen sich voneinander unterscheiden, wobei jeder Resonator mindestens einen Satz obere, interdigitale Elektroden beinhaltet, welche eine periodische Struktur mit einer Periode ($\Lambda_{ij}$) aufweisen und eine Schicht aus piezoelektrischem Material, welche zu dem Stapel gehört, wobei die Elektroden auf Höhe einer Seite des piezoelektrischen Materials befindlich sind, welche derjenigen Seite abgewandt ist, die dem Substrat zugewandt ist, wobei jeder Resonator durch einen Kopplungskoeffizienten ($k^2 1$, $k^2 2$,...,$k^2 n$) und eine Resonanzfrequenz ($fr_1$,...,$fr_2$,...,$f_N$) **gekennzeichnet ist, dadurch** gekennzeichnet, dass:
- mindestens einer der Filter eine Differenzierungsschicht (CDf$_i$) gegenüber dem anderen der beiden Filter beinhaltet, welche dem Stapel angehören;
- die Dicke und/oder die Dichte der Differenzierungsschicht und die Periode der Elektroden in der Weise gestaltet sind, dass gleiche Nutzbandbreiten für die beiden Filter erzielt werden.

2.  Mit geführten akustischen Wellen arbeitende Resonanzvorrichtung, beinhaltend einen Resonator nach Anspruch 1, **dadurch gekennzeichnet, dass** die Differenzierungsschicht(en) an der Oberfläche der Resonatoren des oder der Filter positioniert ist/sind.

3.  Mit geführten akustischen Wellen arbeitende Resonanzvorrichtung, beinhaltend einen Resonator nach einem der Ansprüche 1 oder 2, **dadurch gekennzeichnet, dass** die Differenzierungsschicht(en) zwischen den Resonatoren des oder der Filter und einem Substrat positioniert ist/sind.

4.  Mit geführten akustischen Wellen arbeitende Resonanzvorrichtung, beinhaltend eine Gruppe von Resonatoren nach Anspruch 3, **dadurch gekennzeichnet, dass** die Resonatoren der Filter an der Oberfläche eines gemeinsamen Stapels von Schichten gebildet sind, welche eine Bragg-Spiegelfunktion gewährleisten, wobei der Bragg-Spiegel an der Oberfläche eines Substrates befindlich ist.

5.  Mit geführten akustischen Wellen arbeitende Resonanzvorrichtung, beinhaltend eine Gruppe von Resonatoren nach Anspruch 4, **dadurch gekennzeichnet, dass** die Differenzierungsschicht(en) einer der Schichten des Stapels angehört/angehören, welche Bestandteil des Bragg-Spiegels sind.

6.  Mit geführten akustischen Wellen arbeitende Resonanzvorrichtung, beinhaltend eine Gruppe von Resonatoren nach einem der Ansprüche 1 bis 5, **dadurch gekennzeichnet, dass** die Differenzierungsschicht(en) poröse Elemente enthält/enthalten, welche es ermöglichen, deren akustische Merkmale zu ändern.

7.  Mit geführten akustischen Wellen arbeitende Resonanzvorrichtung, beinhaltend eine Gruppe von Resonatoren nach einem der Ansprüche 1 bis 5, **dadurch gekennzeichnet, dass** die Differenzierungsschicht(en) Subwellenlängen-Muster enthält/enthalten.

8.  Mit geführten akustischen Wellen arbeitende Resonanzvorrichtung, beinhaltend eine Gruppe von Resonatoren nach einem der Ansprüche 1 bis 7, **dadurch gekennzeichnet, dass** mindestens ein Teil der Filter mehrere Differenzierungsschichten enthält.

9.  Mit geführten akustischen Wellen arbeitende Resonanzvorrichtung, beinhaltend eine Gruppe von Resonatoren nach einem der Ansprüche 1 bis 8, **dadurch gekennzeichnet, dass** die Resonatoren der Filter zudem eine sogenannte untere Elektrode beinhalten, welche der oberen Elektrode zugewandt ist.

10. Mit geführten akustischen Wellen arbeitende Resonanzvorrichtung, beinhaltend eine Gruppe von Resonatoren nach Anspruch 9, **dadurch gekennzeichnet, dass** die sogenannte untere Elektrode eine durchgehende Elektrode ist.

11. Mit geführten akustischen Wellen arbeitende Resonanzvorrichtung, beinhaltend eine Gruppe von Resonatoren nach Anspruch 9, **dadurch gekennzeichnet, dass** die untere Elektrode ein Kamm aus interdigitalen Elektroden ist.

12. Mit geführten akustischen Wellen arbeitende Resonanzvorrichtung, beinhaltend eine Gruppe von Resonatoren nach einem der Ansprüche 1 bis 3 oder 6 bis 11, **dadurch gekennzeichnet, dass** die Vorrichtung eine mit den Resonatoren gekoppelte Membranstruktur beinhaltet, welche es ermöglicht, einen Spalt zu schaffen, der in der Lage ist, die akustischen Wellen in dem piezoelektrischen Material einzuschließen.

**Claims**

1.  Guided acoustic wave resonant device comprising:

    - a stack of layers produced on the surface of a substrate (S);
    - at least two filters ($F_1$,...,$F_i$,...,$F_N$), produced on said stack of layers, each filter comprising at least two guided acoustic wave resonators ($R_{11}$-$R_{12}$,...,$R_{i1}$-$R_{i2}$,...,$R_{N1}$-$R_{N2}$), each filter being **characterised by** a useful frequency

bandwidth ($BF_1$, ..., $BF_i$,..., $BF_N$) centred on a central frequency ($f_1$,...,$f_i$,...,$f_N$), said central frequencies being different to each other, each resonator comprising at least one suite of interdigitated upper electrodes exhibiting a periodic structure of period ($\Lambda_{ij}$) and a layer of piezoelectric material being part of said stack, said electrodes being located on a face of the piezoelectric material opposed to the one which faces said substrate, each resonator being **characterized by** a coupling coefficient ($k^21$, $k^22$, ..., $k^2n$) and a resonant frequency ($f_{r1}$,...,$f_{r2}$,...,$f_N$), **characterised in that**:
- at least one of the filters comprises a differentiation layer ($CDf_i$) compared to the other of said two filters being part of said stack;
- the thickness and/or density of said differentiation layer and the period of said electrodes being arranged so as to obtain equal widths of the useful bandwidth for said two filters.

2. Guided acoustic wave resonant device comprising a resonator according to claim 1, **characterised in that** the differentiation layer(s) is/are positioned on the surface of the resonators of said filter(s).

3. Guided acoustic wave resonant device comprising a resonator according to one of claims 1 or 2, **characterised in that** the differentiation layer(s) is/are positioned between the resonators of said filter(s) and a substrate.

4. Guided acoustic wave resonant device comprising a set of resonators according to claim 3, **characterised in that** the resonators of the filters are produced on the surface of a common stack of layers ensuring a Bragg mirror function, said Bragg mirror being on the surface of a substrate.

5. Guided acoustic wave resonant device comprising a set of resonators according to claim 4, **characterised in that** the differentiation layer(s) belong to one of the layers of the stack constituting the Bragg mirror.

6. Guided acoustic wave resonant device comprising a set of resonators according to any one of claims 1 to 5, **characterised in that** the differentiation layer(s) comprise porous elements making it possible to modify the acoustic characteristics thereof.

7. Guided acoustic wave resonant device comprising a set of resonators according to any one of claims 1 to 5, **characterised in that** the differentiation layer(s) comprise sub-wavelength patterns.

8. Guided acoustic wave resonant device comprising a set of resonators according to one of Claims 1 to 7, **characterised in that** at least one part of the filters comprises several differentiation layers.

9. Guided acoustic wave resonant device comprising a set of resonators according to one of claims 1 to 8, **characterised in that** the resonators of said filters furthermore comprise a so-called lower electrode facing the upper electrode.

10. Guided acoustic wave resonant device comprising a set of resonators according to claim 9, **characterised in that** the so-called lower electrode is a continuous electrode.

11. Guided acoustic wave resonant device comprising a set of resonators according to claim 9, **characterised in that** the lower electrode is a comb of interdigitated electrodes.

12. Guided acoustic wave resonant device comprising a set of resonators according to one of claims 1 to 3 or 6 to 11, **characterised in that** the device comprises a membrane structure coupled to the resonators making it possible to create a gap capable of confining the acoustic waves in the piezoelectric material.

FIG.1a

FIG.1b

FIG.1c

FIG.1d

FIG.1e

FIG.1f

FIG.2a

FIG.2b

FIG.3

FIG.4

FIG.5

FIG.6

FIG.7

FIG.8a

FIG.8b

FIG.8c

FIG.8d

$M_R$ {

S

**FIG.9a**

P

$M_R$ {

S

**FIG.9b**

$E_{Rij}$

P

$M_R$ {

S

**FIG.9c**

$E_{Rij}$     $CD_{f2}$     $CD_{f1}$

P     $F_3$     $F_2$     $F_1$

$M_R$ {

S

**FIG.9d**

**FIG.10a**

**FIG.10b**

**FIG.10c**

**FIG.10d**

FIG.11a

FIG.11b

FIG.11c

FIG.11d

FIG.11e

FIG.11f

FIG.12a

$M_R$
$S$

FIG.12b

$Ei_{ij}$
$M_R$
$S$

FIG.12c

$P$
$Ei_{ij}$
$M_R$
$S$

FIG.12d

$E_{Rij}$
$Ei_{ij}$
$M_R$
$S$

FIG.12e

$CD_a$
$F_3$ $F_2$ $F_1$
$M_R$
$S$

FIG.12f

$CD_a$ $CD_b$ $E_{Rij}$
$P$
$Ei_{ij}$
$M_R$
$S$

FIG.13a

FIG.13b

FIG.13c

FIG.13d

FIG.13e

FIG.13f

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006087496 A1
- US 6734600 B2, R.F. Milsom, F.W. Vanhelmont, A. Jansman, J. Ruigrok et H.P. Loebl
- WO 2006126168 A1, J. Kuypers et A. Pisano
- US 20070241841 A
- US 6657363 B1, R. Aigner

**Littérature non-brevet citée dans la description**

- **R. AIGNER ; J. ELLA.** *Component for forming vertically standing waves of a wavelength*
- **R.J.M. DA FONSECA ; J.M. SAUREL ; G. DESPAUX ; A. FOUCARAN ; E. MASSONNE ; T. TALIERCO ; P. LEFEBVRE.** *Superlattices Microstruct.,* 1994, vol. 16, 21
- **D. BELLET, P. LAMAGNÈRE ; A. VINCENT ; Y. BRÉCHET.** *J. Appl. Phys.,* 1996, vol. 80, 3772
- **G.T. ANDREWS ; J. ZUK ; H. KIEFTE ; M.J. CLOUTER ; E. NOSSARZEWSKA-ORLOWSKA.** *Appl. Phys. Lett.,* 1996, vol. 69, 1217